# EUROPEAN PATENT SPECIFICATION

(11) **EP 2 851 451 B1**
(45) Date of publication and mention of the grant of the patent: **26.12.2018**
(21) Application number: 14185029.7
(22) Date of filing: 16.09.2014
(51) Int. Cl.: C23C 14/32, C23C 14/06, C23C 14/02, C23C 28/04, C23C 28/00

(54) **Amorphous-carbon-containing film**
Beschichtung mit amorphem Kohlenstoff
Film contenant du carbone amorphe

(30) Priority: 24.09.2013 JP 2013196793
(43) Date of publication of application: 25.03.2015
(73) Proprietor: UNION TOOL CO., Tokyo (JP)
(72) Inventor: Suwa, Koji, Tokyo (JP); Hirose, Keita, Tokyo (JP); Sato, Akira, Tokyo (JP); Watanabe, Yuji, Tokyo (JP)
(74) Representative: Kramer Barske Schmidtchen Patentanwälte PartG mbB

(56) References cited:
- EP-A1- 2 671 967
- US-A1- 2010 211 180
- US-A1- 2011 220 415
- TEO EDWIN ET AL: "Thermal stability of nonhydrogenated multilayer amorphous carbon prepared by the filtered cathodic vacuum arc technique", JOURNAL OF VACUUM SCIENCE AND TECHNOLOGY: PART A, vol. 25, no. 3, 9 March 2007 (2007-03-09), pages 421-424, XP012102599, AVS /AIP, MELVILLE, NY., US ISSN: 0734-2101, DOI: 10.1116/1.2712193
- SILVA S R P ET AL: "Electron energy loss spectroscopy of carbonaceous materials", THIN SOLID FILMS, vol. 488, no. 1-2, 22 September 2005 (2005-09-22), pages 283-290, XP027865718, ELSEVIER-SEQUOIA S.A. LAUSANNE, CH ISSN: 0040-6090 [retrieved on 2005-09-22]
- PONSONNET L ET AL: "EELS analysis of hydrogenated diamond-like carbon films", THIN SOLID FILMS, vol. 319, no. 1-2, 29 April 1998 (1998-04-29), pages 97-100, XP004147859, ELSEVIER-SEQUOIA S.A. LAUSANNE, CH ISSN: 0040-6090, DOI: 10.1016/S0040-6090(97)01094-8
- WANG N ET AL: "The multilayered structure of ultrathin amorphous carbon films synthesized by filtered cathodic vacuum arc deposition", JOURNAL OF MATERIALS RESEARCH, vol. 28, no. 16, 28 August 2013 (2013-08-28), pages 2124-2131, XP002732177, CAMBRIDGE UNIVERSITY PRESS USA DOI: 10.1557/JMR.2013.206
- A. FERRARI ET AL: "Density, sp3 fraction, and cross-sectional structure of amorphous carbon films determined by x-ray reflectivity and electron energy-loss spectroscopy", PHYSICAL REVIEW B, vol. 62, no. 16, 1 October 2000 (2000-10-01), pages 11089-11103, XP055151495, ISSN: 0163-1829, DOI: 10.1103/PhysRevB.62.11089

## Description

### FIELD OF THE INVENTION

The present invention relates to an amorphous-carbon-containing film for coating machining tools for use with soft metals, non-ferrous metals, organic materials, or the like, as well as sliding parts constituted by machine parts.

### BACKGROUND OF THE INVENTION

When cutting materials such as soft metals such as aluminum or copper, non-ferrous metals such as titanium or magnesium, or organic materials such as plastic using a cutting tool made of a steel material such as cemented carbide or tool steel, cermet, or ceramic, the problems arise that not only is satisfactory longevity unobtainable due to the cutting tool material not having a high level of hardness, but swarf also adheres to the cutting edge of the cutting tool, thereby increasing cutting resistance, shortening the longevity of the cutting tool, and roughening the cut surface.

In addition, when performing forging with a mold made of a steel material such as cemented carbide or mold steel using one of the abovementioned soft metals, non-ferrous metals, or organic materials as a molding material, adhesion of the molding material to the surface of the mold can shorten mold longevity, and, if these materials are used to perform casting with the mold, the lack of lubricity impedes the release of the molded product from the mold, leading to the problem (hereafter, such cutting tools and molds will be collectively referred to as machining tools, and cut materials and molded materials as machined materials).

Resistance to machined material adhesion is an important factor in the surface treatment of machining tools made from such soft metals, non-ferrous metals, or organic materials.

Meanwhile, the low affinity of amorphous carbon films with metal materials and organic materials and their superior adhesion resistance, seizing resistance, and lubricity makes such films suited for surface treatment of machining tools intended for use upon machined materials such as soft metals, non-ferrous metals, and organic materials, leading to their wide use for this purpose.

There has also been a demand in recent years for further improvement in the longevity of and machined surface quality yielded by cemented carbide and steel material tools used to cut machined materials such as soft metals, non-ferrous metals, and organic materials. Apart from the adhesion resistance needed to improve machining tool longevity and machined surface quality, wear resistance and high bondability are also necessary to improve longevity.

Patent document 1, for example, discloses a tool upon the surface of which is formed a wear-resistant and adhesion-resistance amorphous carbon film. However, it is not always possible to obtain satisfactory tool longevity or machined surface quality when coating a tool with an amorphous carbon film and performing a high-speed cutting test according to the method disclosed in patent document 1. Specifically, investigation of tool longevity and machined surface quality obtained when using the amorphous carbon film coating disclosed in document 1 revealed not only that the cutting blades of cemented carbide and steel material tools exhibited wear, but also that cut material adhered to parts where the substrate was exposed due to peeling of the amorphous carbon film, reducing machined surface quality, and that cut material adhesion increased cutting resistance, damaging the tip of the cutting blade and reducing tool longevity.

Meanwhile, in fields such as automobile parts, information devices, household electronics, and industrial machinery, there is a demand for reduced energy consumption and lubricant/grease usage out of concerns for preventing global warming and protecting the environment. One means of solving such problems are methods of reducing sliding part friction. The surface smoothness and high hardness of amorphous carbon films allows them to reduce sliding part friction even in un-lubricated conditions, and such films are starting to be applied to sliding surfaces of many types of machine parts at present.

Until recently, there had been few instances of the practical application of amorphous carbon films to the sliding surfaces of machine parts such to problems with their ability to bond to the steel substrate constituting the sliding surface, but advances in film-forming apparatus and technology over the past few years has led to such films being applied to a rapidly growing range of parts. Thus, as the demand for the formation of amorphous carbon films on sliding surfaces has been increasing, there is also, meanwhile, an increased demand for amorphous carbon films capable of withstanding usage in severe environments involving high surface pressures, high rotational speeds, high temperatures, and zero lubrication. Hydrogen-free, high-hardness amorphous carbon films show promise as amorphous carbon films of high hardness and superior wear resistance capable of withstanding such demanding applications.

Patent document 2, for example, discloses a technique of forming a hydrogen-free, high-hardness amorphous carbon film on sliding parts of various mechanical devices. However, hydrogen-free, high-hardness amorphous carbon films are subject to high levels of interior stress, and easily peel off. Thus, although conventional amorphous carbon films have high hardness and superior wear resistance, they have poor bonding strength, preventing sufficient wear resistance being obtained over extended usage. Film bond strength is also extremely important in ensuring that sliding parts exhibit low friction.

### [Prior Art Literature]

### [Patent Literature]

[Patent Document 1] Japanese Unexamined Patent Application Publication No. 2009-241252
[Patent Document 2] Japanese Unexamined Patent Application Publication No. 2008-297477

Teo Edwin et al: "Thermal stability of nonhydrogenated multilayer amorphous carbon prepared by the filtered cathodic vacuum arc technique", Journal of Vacuum Science and Technology: Part A, vol. 25, no. 3, 9 March 2007 (2007-03-09), pages 421-424, XP012102599, AVS /AIP, Melville, NY., US, ISSN: 0734-2101, DOI: 10.1116/1.2712193, paragraph [0002], discloses multilayered nonhydrogenated diamondlike amorphous carbon films prepared by the filtered cathodic vacuum arc technique.

S R P Silva et al: "Electron energy loss spectroscopy of carbonaceous materials", Thin Solid Films, vol. 488, no. 1-2, 22 September 2005 (2005-09-22), pages 283-290, XP027865718, Elsevier-Sequoia S.A. Lausanne, CH, ISSN: 0040-6090, discloses an examination of the properties of diamond-like carbon thin films on a nanometre scale in order to explore the possibility of fabricating amorphous carbon based superlattices for electronic applications.

US 2010/0211180 A1 discloses tetrahedral amorphous carbon coated medical devices.

US 2011/0220415 A1 relates to ultra-low friction coatings for drill stem assemblies.

EP 1760172 A2 discloses a DLC multilayer for a cutting tool.

### SUMMARY OF THE INVENTION

The inventors arrived at the present invention following the discovery, as the result of research into the film properties and layer structure of amorphous carbon films in view of the circumstances described above, that the abovementioned problems can be solved by modifying these properties and layer structure, and the present invention provides an amorphous-carbon-containing film according to claim 1 that has high levels of hardness and substrate bonding strength, is capable of greatly extending the longevity of machining tools and machine parts, and exhibits an extremely high level of practical usefulness.

The main point of the present disclosure will be described hereafter.

The present disclosure provides an amorphous-carbon-containing film formed upon a substrate, wherein the film is constituted by an amorphous carbon film layer [A] and an amorphous carbon film layer [B] that measure at least 0.05 µm in thickness and are layered so that the amorphous carbon film layer [A] is disposed nearer the substrate and the amorphous carbon film layer [B] is disposed nearer the surface, the overall thickness of the amorphous-carbon-containing film is at least 0.1 µm and no more than 1.5 µm, and, when a cross-section of the amorphous-carbon-containing film is irradiated with an electron beam to perform electron energy loss spectroscopy, X, which is defined as set forth below, is greater for the amorphous carbon film layer [A] than for the amorphous carbon film layer [B], X being 0.2-0.6 for amorphous carbon film layer [A].

Assuming that the electron energy loss spectrum measured via electron energy loss spectroscopy is the sum of the following six Gaussian functions (1) - (6), X is defined as IJ/IL, where IJ is the peak intensity of J and IL is the peak intensity of L when peaks are extracted from the electron energy loss spectrum.
(1) J having a peak at 277-287 eV
(2) K having a peak at 283-293 eV
(3) L having a peak at 289-299 eV
(4) M having a peak at 295-305 eV
(5) N having a peak at 311-321 eV
(6) P having a peak at 325-335 eV

The present disclosure also provides the amorphous-carbon-containing film according to the first aspect, wherein X is 0.3-0.5 for the amorphous carbon film layer [A].

The present disclosure also provides the amorphous-carbon-containing film according to the first aspect, further provided with an amorphous carbon film layer [C] as an outermost layer, X being less for the amorphous carbon film layer [C] than for the amorphous carbon film layer [B] when a cross-section of the amorphous-carbon-containing film is irradiated with an electron beam to perform electron energy loss spectroscopy.

The present disclosure also provides the amorphous-carbon-containing film according to the second aspect, further provided with an amorphous carbon film layer [C] as an outermost layer, X being less for the amorphous carbon film layer [C] than for the amorphous carbon film layer [B] when a cross-section of the amorphous-carbon-containing film is irradiated with an electron beam to perform electron energy loss spectroscopy.

The present disclosure also provides the amorphous-carbon-containing film according to the first aspect, wherein the film does not contain hydrogen apart from inevitable impurities.

The present disclosure also provides the amorphous-carbon-containing film according to the second aspect, wherein the film does not contain hydrogen apart from inevitable impurities.

The present disclosure also provides the amorphous-carbon-containing film according to the third aspect, wherein the film does not contain hydrogen apart from inevitable impurities.

The present disclosure also provides the amorphous-carbon-containing film according to the fourth aspect, wherein the film does not contain hydrogen apart from inevitable impurities.

The present disclosure also provides the amorphous-carbon-containing film according to any one of the first through the eighth aspects, further provided with a metal film layer [D] as a bottommost layer, wherein the metal film layer [D] is constituted by at least one metal element from group 4a, 5a, or 6a of the periodic table, the metal film layer [D] measuring at least 0.01 µm and no more than 0.1 um in thickness, and the amorphous carbon film layer [A] being provided over the metal film layer [D].

The present disclosure also provides the amorphous-carbon-containing film according to the ninth aspect, wherein the metal film layer [D] is constituted by Zr.

The present disclosure also provides the amorphous-carbon-containing film according to any one of the first through the eighth aspects, wherein the film coats a substrate of any of cemented carbide, a steel material, or ceramic.

The present disclosure also provides the amorphous-carbon-containing film according to the ninth aspect, wherein the film coats a substrate of any of cemented carbide, a steel material, or ceramic.

The present disclosure also provides the amorphous-carbon-containing film according to the tenth aspect, wherein the film coats a substrate of any of cemented carbide, a steel material, or ceramic.

In accordance with the present disclosure, configured as described above, it is possible to provide an amorphous-carbon-containing film that has high levels of hardness and substrate bonding strength, is capable of greatly extending the longevity of machining tools and machine parts, and exhibits an extremely high level of practical usefulness.

### BRIEF DESCRIPTION OF THE DRAWINGS

FIG. 1 is a schematic illustration of film layer patterns;
FIG. 2 is a schematic illustration of a film-forming apparatus;
FIG. 3 is a table showing testing conditions and test results for a cutting tool (router);
FIG. 4 is a table showing testing conditions and test results for a sliding part (steel bearing ball); and
FIG. 5 is a graph showing electron energy loss spectroscopy and peak extraction results.

### DETAILED DESCRIPTION OF THE INVENTION

A preferred embodiment of the present invention will be described hereafter with reference to the operation of the present invention.

The amorphous carbon film of a predetermined configuration constituted by layering the amorphous carbon film layer [A] and the amorphous carbon film layer [B] having predetermined properties exhibits superior hardness and bond strength as a protective film, allowing it to improve the tool longevity of a machining tool or the sliding longevity of a machine part coated therewith.

### EMBODIMENTS

A specific embodiment of the present disclosure will be described hereafter with reference to the drawings.

The present embodiment is an amorphous-carbon-containing film formed upon a substrate, the film constituted by an amorphous carbon film layer [A] and an amorphous carbon film layer [B], each of which layers having a thickness of at least 0.05 µm and being layered so that the amorphous carbon film layer [A] is disposed nearer the substrate and the amorphous carbon film layer [B] is disposed nearer the surface, the overall thickness of the amorphous-carbon-containing film is at least 0.1 µm and no more than 1.5 µm, and, when a cross-section of the amorphous-carbon-containing film is irradiated with an electron beam to perform electron energy loss spectroscopy, X is greater for the amorphous carbon film layer [A] than for the amorphous carbon film layer [B], and X is 0.2-0.6 for the amorphous carbon film layer [A], X being defined as follows: assuming that the electron energy loss spectrum measured via electron energy loss spectroscopy is the sum of the six Gaussian functions of J having a peak at 277-287 eV, K having a peak at 283-293 eV, L having a peak at 289-299 eV, M having a peak at 295-305 eV, N having a peak at 311-321 eV, and P having a peak at 325-335 eV, X is defined as IJ/IL, where IJ is the peak intensity of J and IL is the peak intensity of L when peaks are extracted from the electron energy loss spectrum,

A router made of cemented carbide constituted by hard particles primarily composed of WC (tungsten carbide) and a binder primarily composed of Co (cobalt) is used as a substrate in the present embodiment. Specifically, the WC particles have an average particle size of 0.1-2 µm, and the router has a Co content of 5-15% by mass.

A metal film layer [D] is provided immediately above the substrate. The metal film layer [D] is constituted by at least one metal element from group 4a 5a, or 6a on the periodic table. The metal film layer [D] has a thickness of at least 0.01 µm and no more than 0.1 µm.

At least one amorphous carbon film layer [A] and amorphous carbon film layer [B] apiece are layered over the metal film layer [D], with the amorphous carbon film layer [A] being disposed nearer the substrate and the amorphous carbon film layer [B] nearer the surface. The metal film layer [D] is constituted by Zr (zirconium).

An amorphous carbon film layer [C] is provided as an outermost layer. When a cross-section of the amorphous-carbon-containing film is irradiated with an electron beam to perform electron energy loss spectroscopy, X is less for the amorphous carbon film layer [C] than for the amorphous carbon film layer [B].

The present embodiment does not contain hydrogen apart from inevitable impurities.

The reasons for the features described above and the effects yielded thereby will be described hereafter.

First, amorphous carbon films and electron energy loss spectroscopy will be discussed. Carbon exhibits different structures according to the form of the bonds between its atoms; broadly speaking, these structures can be divided into diamond, graphite, and amorphous carbon. In diamond, the bonds between carbon atoms are σ bonds constituted by sp³ hybridized orbitals ("sp³ bonds"), with one carbon atom being the center of a regular tetrahedron at whose apexes are disposed other carbon atoms spreading three-dimensionally outward. The hardness of diamond derives from these sp³ bonds. Graphite has a layered structure. The carbon atoms form π bonds constituted by sp² hybridized orbitals ("sp² bonds") in crystalline planes parallel to the layers, and the layers are bonded to each other by the van der Waals force. The hardness of graphite is less than that of diamond. In amorphous carbon, both sp² bonds and sp³ bonds are present. Diamond-like properties are strongly manifested in amorphous carbon films comprising numerous sp³ bonds, imparting them with a high level of hardness. Conversely, graphite-like properties are strongly manifested in amorphous carbon films comprising numerous sp² bonds, imparting them with a low level of hardness.

Electron energy loss spectroscopy is a method allowing the ratio of sp² bonds and sp³ bonds in carbon to be directly calculated. In general, peaks near 284 eV in the energy loss spectrum correspond to sp² bonds, and peaks near 291 eV to sp³ bonds, and the ratio of these bonds is often used as a rating value for amorphous carbon films.

In the present embodiment, assuming that the electron energy loss spectrum is the sum of the six Gaussian functions of J having a peak at 277-287 eV, K having a peak at 283-293 eV, L having a peak at 289-299 eV, M having a peak at 295-305 eV, N having a peak at 311-321 eV, and P having a peak at 325-335 eV, X is defined as IJ/IL, where IJ is the peak intensity of J and IL is the peak intensity of L when peaks are extracted from the electron energy loss spectrum; X being used as a rating value for the amorphous carbon film. A relatively small value for X indicates that more sp³ bonds are contained, and a large value that there are more sp² bonds.

By coating routers with amorphous carbon films under various film formation conditions and using the routers to perform cutting tests upon aluminum sheets, the inventors discovered that router machining distance (the distance over which good-quality machining can be performed without router breakage or burr formation on the machined surface) can be increased by layering amorphous carbon films having different X values. The X value of the amorphous carbon film is set by adjusting the discharge voltage of the carbon vapor source during film formation.

Specifically, if an amorphous carbon film layer [A] is disposed directly upon the substrate (i.e., as a bottommost layer), and an amorphous carbon film layer [A] is disposed thereupon, router machining distance will be especially improved if the value of X is greater for the amorphous carbon film layer [B] than for the amorphous carbon film layer [B], and the value of X for the amorphous carbon film layer [A] is 0.2-0.6.

The amorphous carbon film layer [A] is formed in order to improve the strength of the bond with the substrate, and the amorphous carbon film layer [B] to minimize exposure of the surface of the substrate via film wear. The layers will be pointless if they are too thin, and both are preferably at least 0.05 µm thick.

As too low an overall thickness for the film will make it impossible to improve tool longevity, the thickness must be at least 0.1 µm. On the other hand, too great a thickness will increase the internal stress of the film, making it more liable to peel; thus, a maximum thickness of 1.5 µm is preferable.

Amorphous-carbon-containing films in which the value of X was 0.2-0.6 for the amorphous carbon film layer [A] yielded good results in cutting tool cutting testing and durability testing using a tribotester. This is believed to be due to the amorphous carbon film layer [A] having less internal stress than the amorphous carbon film layer [B], thereby impeding peeling of the amorphous-carbon-containing film.

Specifically, an X value of less than 0.2 will lead to high hardness and increase the internal stress of the film, making it liable to peel off the substrate. An X value exceeding 0.6 will lead to excessively low hardness and reduced film quality, causing cracks to form in the amorphous carbon film layer [A] and creating the possibility of the film peeling from the substrate.

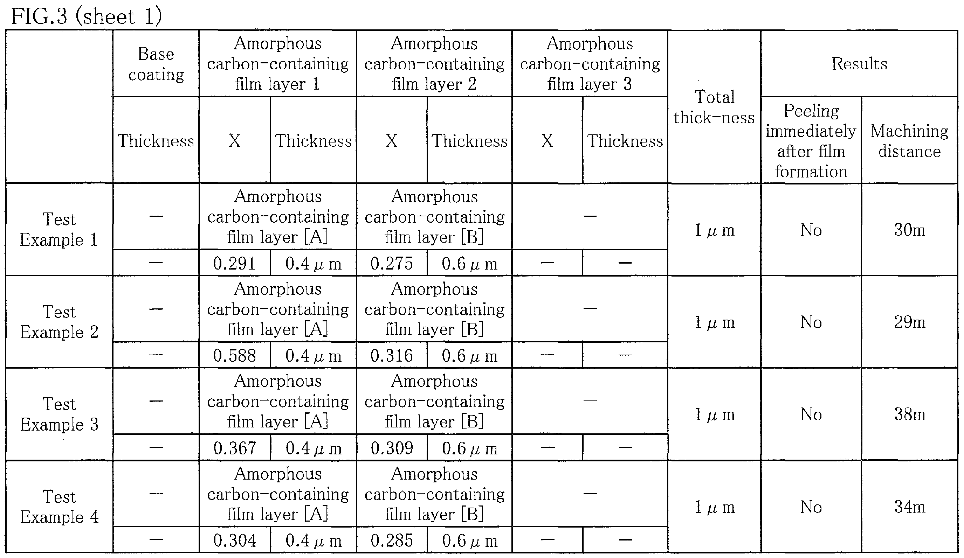

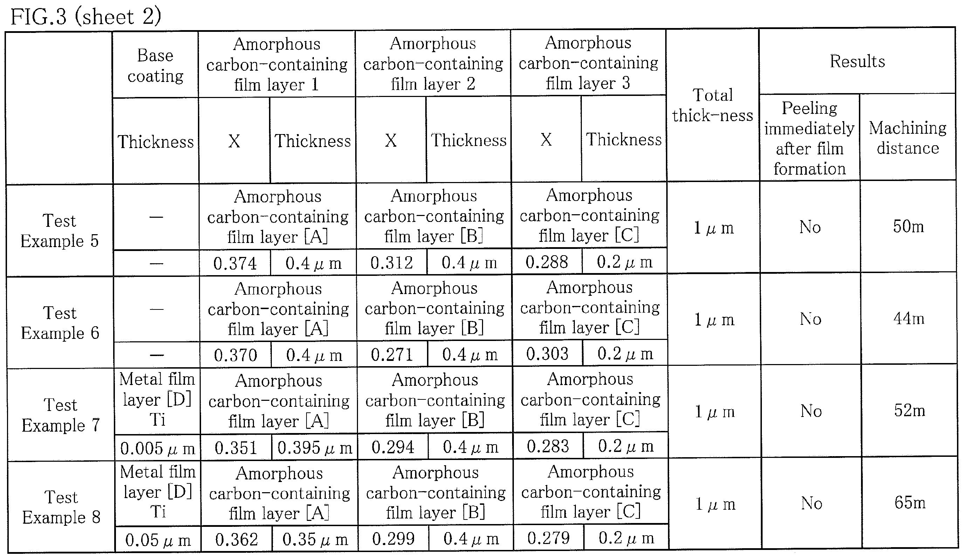

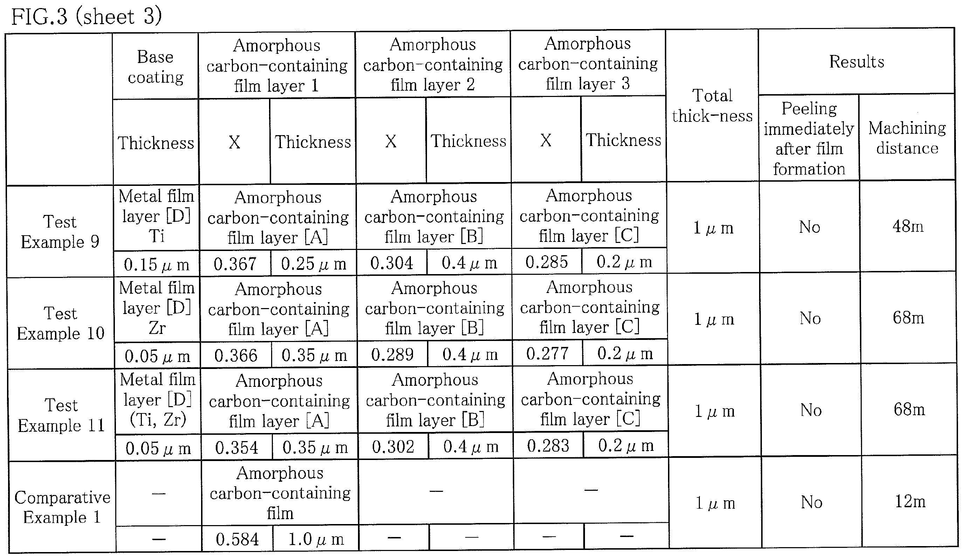

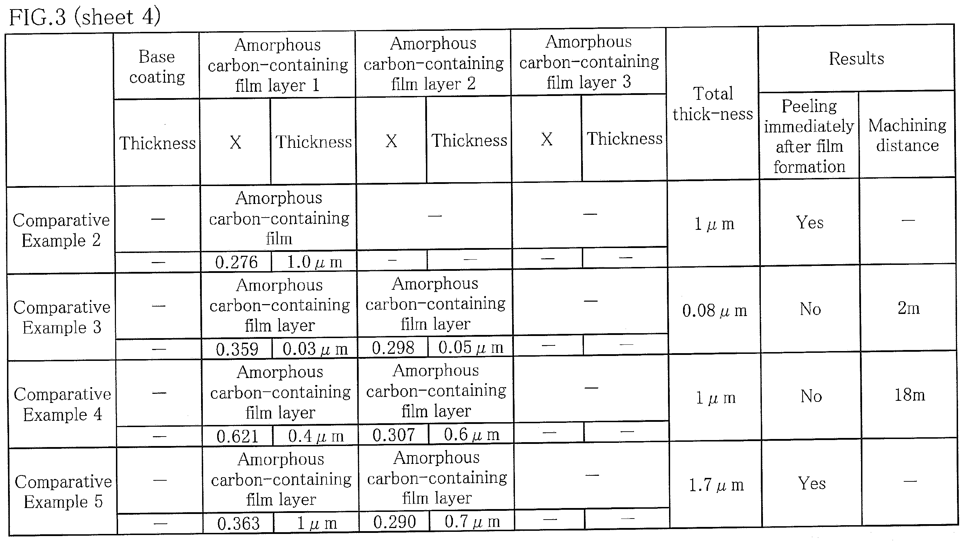

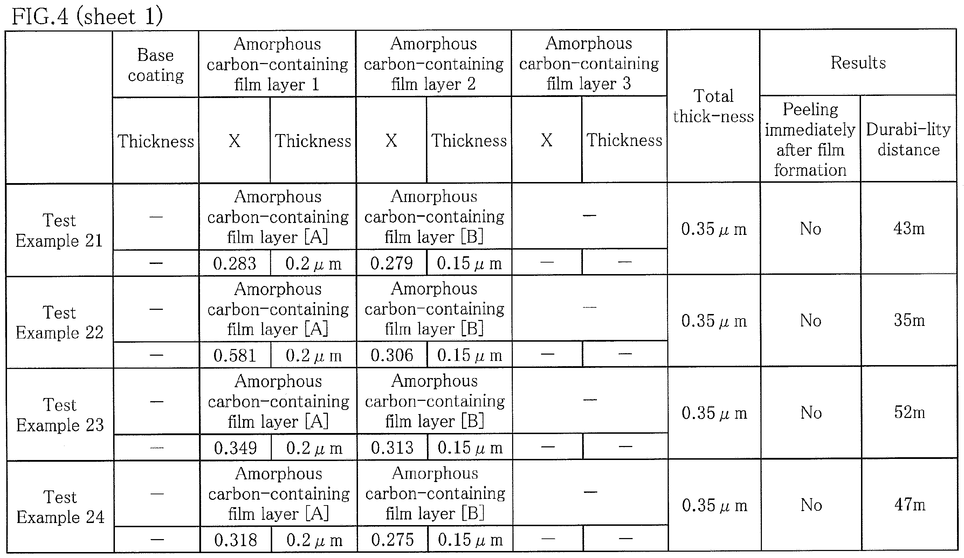

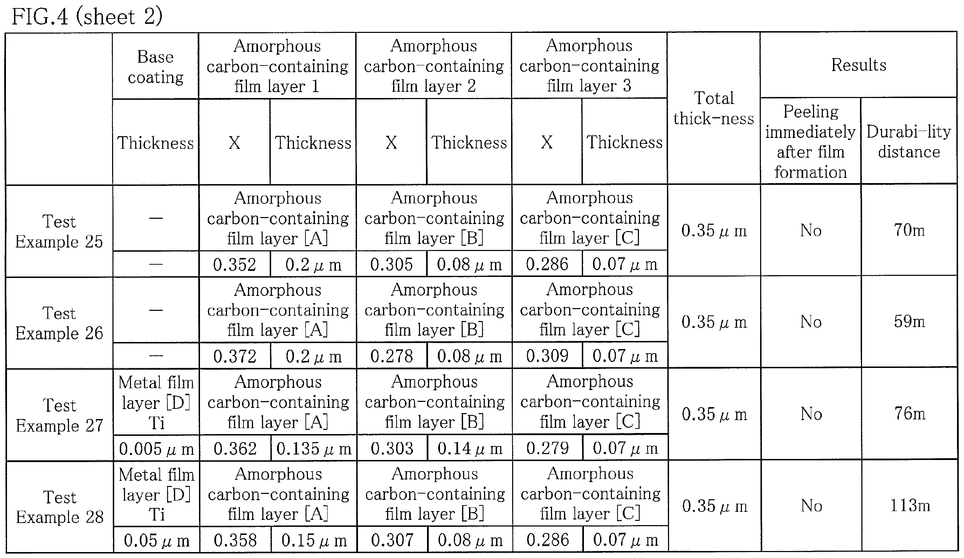

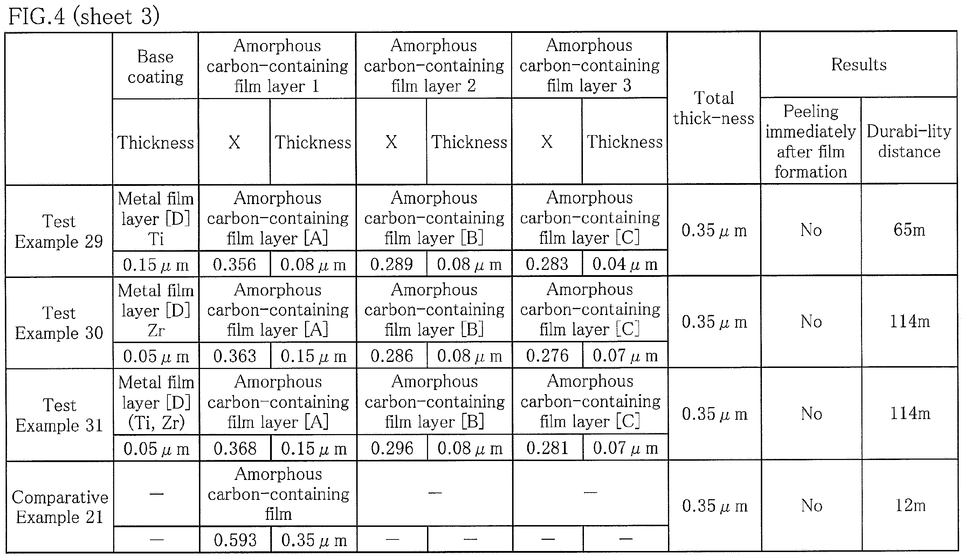

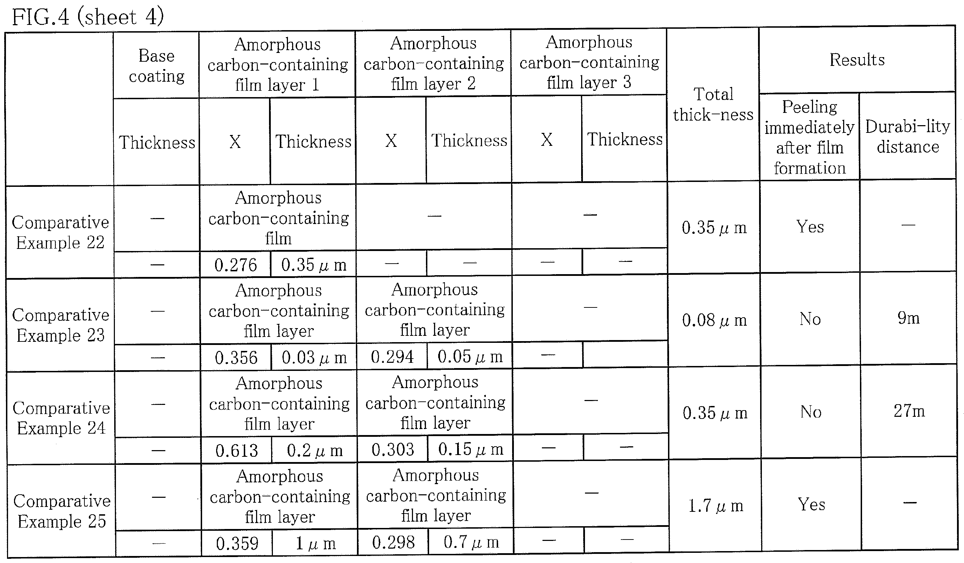

As is apparent from the test examples described below (see FIGS. 3 and 4), an X value of 0.3-0.5 for the amorphous carbon film layer [A] is more preferable, as this will increase machining distance and durability distance (the distance until the film peels or is worn off) (see test examples 3-11 in FIG. 3 and test examples 23-31 in FIG. 4). The difference between the X value for the amorphous carbon film layer [A] and the X value for the amorphous carbon film layer [B] is preferably 0.3 or less, as a difference greater than 0.3 will lead to a large difference in quality between the amorphous carbon film layer [A] and the amorphous carbon film layer [B], potentially leading to peeling at the interface of the film layers.

It is also preferable to provide an amorphous carbon film layer [C] as an outermost layer. The amorphous carbon film layer [C], which is characterized in having a smaller X value than the amorphous carbon film layer [B], comprises a comparatively higher amount of sp³ bonds than the amorphous carbon film layer [B], bringing it closer to the properties of diamond and yielding a film of high hardness. An amorphous-carbon-containing film in which an amorphous carbon film layer [C] is disposed as the outermost layer will be more capable of minimizing substrate surface exposure due to film wear compared to an amorphous-carbon-containing film having an amorphous carbon film layer [B] as the outermost layer, allowing tool longevity to be extended. If the amorphous carbon film layer [C] is too thin, the wear resistance effect yielded by the high hardness will not be clearly manifested, and, if it is too thick, internal stress will increase, decreasing bond strength and leading to a tendency to peel, with the result that the wear resistance effect is not manifested. Thus, the thickness of the amorphous carbon film layer [C] is preferably no less than 0.04 µm and no more than 1.0 µm, more preferably no less than 0.04 µm and no more than 0.5 µm. In addition, the thickness of the amorphous carbon film layer [C] is more preferably no greater than the sum of the thicknesses of the amorphous carbon film layers [A] and [B], as this will improve the bond strength of the amorphous carbon film layers [A], [B], and [C]. The thickness is 0.2 µm in FIG. 3 (test examples 5-11), and 0.04 µm (test example 29) and 0.07 µm (test examples 25-28, 30, and 31) in FIG. 4.

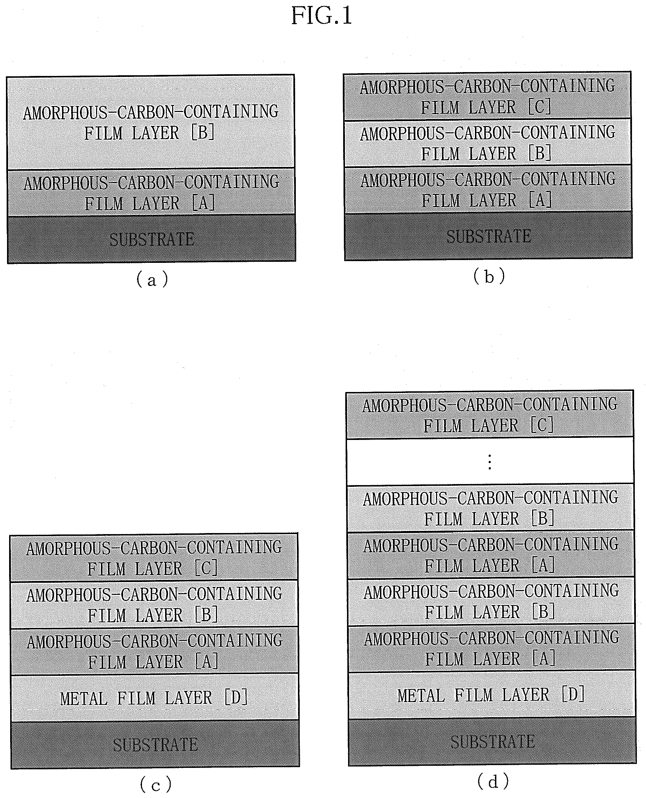

FIG. 1 shows examples of film layer patterns. In FIG. 1(a), one amorphous carbon film layer [A] is provided on the substrate, and an amorphous carbon film layer [B] is provided upon the amorphous carbon film layer [A] as an outermost layer. In FIG. 1(b), one amorphous carbon film layer [A] is provided upon the substrate, one amorphous carbon film layer [B] is provided upon the amorphous carbon film layer [A], and one amorphous carbon film layer [C] is provided upon the amorphous carbon film layer [B] as an outermost layer. In FIG. 1(c), a metal film layer [D] is provided upon the substrate, one amorphous carbon film layer [A] is provided upon the metal film layer [D], one amorphous carbon film layer [B] is provided upon the amorphous carbon film layer [A], and one amorphous carbon film layer [C] is provided upon the amorphous carbon film layer [B] as an outermost layer.

FIG. 1(a), (b), and (c) all feature two-layered configurations in which one amorphous carbon film layer [A] and amorphous carbon film layer [B] apiece are provided, but a layered film layer in which three or more amorphous carbon film layers [A] and amorphous carbon film layers [B] are layered in alternation is also acceptable; such a configuration will relieve internal stresses within the layered film layer and improve interlayer bond strength while maintaining a high level of hardness for the amorphous carbon film layer [B].

FIG. 1(d) shows an example in which a layered film layer has been applied to the configuration shown in FIG. 1(c); specifically, a metal film layer [D] is provided upon a substrate, a plurality of two layer structures ([A]+[B]) in which one amorphous carbon film layer [B] is provided upon one amorphous carbon film layer [A] are provided upon the metal film layer [D], and one amorphous carbon film layer [C] is provided as an outermost layer. Specifically, providing two two-layered structures yields a six-layered construction [D]+[A]+[B]+[A]+[B]+[C], and providing three thereof yields an eight-layered construction [D]+[A]+[B]+[A]+[B]+[A]+[B]+[C]. Even more two-layered structures may be provided if the total thickness of [A]+[B] is no more than 1.5 µm.

The amorphous carbon film according to the present embodiment is substantially hydrogen-free (i.e., is what is known as "hydrogen-free" DLC); in the context of the present embodiment, "substantially hydrogen-free" means that the film was formed while deliberately abstaining from introducing gases having hydrogencontaining molecules into the film-forming apparatus. Hydrogen gas or water permeating or adsorbed to the inner walls or electrodes of the film-forming apparatus, the carbon vapor source, the film substrate, or the like may be released into the film, leading to the intrusion of hydrogen into the film, making it possible to eliminate hydrogen completely, but the amount thereof will normally be no more than 5 at%.

Analysis of the hydrogen content of the film of test example 5 via elastic recoil detection analysis (ERDA) indicated the presence of 3 at% as inevitable impurities. As shall be apparent, a lower hydrogen content corresponds to a stronger bond with the substrate, and a level near 0 at% will yield even more superior properties, yielding an even more desirable amorphous carbon film.

The configuration of the present embodiment as described above allows a more superior bond with the substrate to be obtained by virtue of the substantially hydrogen-free amorphous carbon film layer, and the substantially hydrogen-free amorphous carbon film layer imparts a low coefficient of friction, yielding superior adhesion resistance and lubricity, and high hardness, yielding wear resistance. Accordingly, using the present embodiment as a film for a tool makes it possible to minimize the adhesion of highly adhesive cut materials such as aluminum alloy or copper alloy, thereby improving tool longevity, while simultaneously yielding satisfactory machined surface quality.

A film having a configuration in which amorphous carbon film layers [A] and [B] or [A], [B], and [C] are layered, as shown in FIG. 1(a) and (b), possesses superior hardness, bond strength, heat resistance, wear resistance, and adhesion resistance as a protective film, allowing satisfactory tool longevity and machined surface quality to be obtained when machining soft metals, non-ferrous metals, organic materials, or the like using a tool coated therewith.

The bond strength between the substrate and the amorphous carbon film can be ensured by cleaning the surface of the substrate via argon bombardment prior to forming the amorphous carbon film. However, it is preferable to further increase the strength of the bond between the substrate and the amorphous carbon film in order to perform stable cutting free of film peeling. By forming a metal film layer [D] constituted by at least one metal element from group 4a, 5a, or 6a of the periodic table, such as titanium, chromium, or tantalum, on the substrate as a base coating and forming the amorphous carbon film thereupon, as shown in FIG. 1(c) and (d), it is possible to further increase the strength of the bond between the substrate and the amorphous carbon film. As the base coating is formed in order to improve bond strength between the substrate and the amorphous carbon film, it is pointless for it to be too thick; thus, a thickness of at least 0.01 µm and no more than 0.1 µm is preferable.

Using zirconium, an element from group 4a of the periodic table, in the metal film layer [D] yielded good test results in cutting tool cutting tests and film durability tests using a tribotester. This is believed to be the result of zirconium having good bond strength with both the substrate and the amorphous carbon film, ensuring suitable bond strength for the film. Using a zirconium-containing alloy (with titanium in test examples 11 and 31) for the metal film layer [D] yielded effects comparable to when zirconium alone was used.

Because the present embodiment exhibits high bond strength with various types of substrates, it can be used to coat not only cemented carbide, but also steel materials such as high-speed steel or carbon tool steel, cermet materials, ceramics, cBN-containing sintered materials, and nitride coating substrates.

Test examples supporting the effects of the present embodiment will be described hereafter.

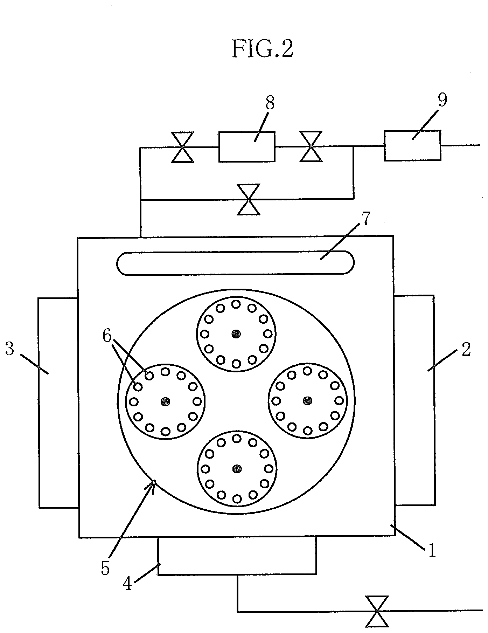

The arc ion plating apparatus shown in FIG. 2 was used as a film-forming apparatus. A metal vapor source 2 for forming the metal film layer, a carbon vapor source 3 for forming the amorphous carbon film layers, an ion gun 4 for argon bombardment, and a film-forming jig 5 for uniform film formation are provided with a chamber 1 of the apparatus. In FIG. 2, reference numeral 6 is a film formation target, numeral 7 a heater, numeral 8 a turbomolecular pump, and numeral 9 a rotary pump. Titanium, zirconium, or an alloy of titanium and zirconium were used to form the metal film layer, and graphite as a carbon vapor source. A router (major diameter: 2.0 mm; groove length: 8.0 mm; total length: 38 mm; shank diameter: 3.175 mm; material: cemented carbide) and a steel bearing ball (diameter: 6 mm; material: high-carbon chromium bearing steel) were used as film formation targets. After installing the router and the steel bearing ball in the film-forming jig, air was vented until a vacuum or 0.02 Pa or less was attained. After first cleaning the surfaces of the router and the steel bearing ball via argon bombardment, an amorphous carbon film was formed. Following argon bombardment of the substrate as necessary, a film of titanium or zirconium was formed, and an amorphous carbon film was formed thereupon. The metal film layer was formed using a discharge voltage of 30 V and a bias voltage of 50 V. A discharge voltage of 50-500 V and a substrate temperature of 100°C or less were used to form amorphous carbon films predetermined thicknesses (0.08-1.7 µm) on the router and the steel bearing ball.

The detailed film formation method used in test examples 1 and 8 shown in Fig. 3 is described below.

### Test Example 1

After installing a router in a film-forming jig in a film-forming apparatus, air was vented until a vacuum of 0.005 Pa was attained, and surfaces of the router were cleaned by argon bombardment. In the argon bombardment, argon gas was introduced so that the degree of vacuum was fixed at 0.5 Pa, an ion gun was caused to discharge at a discharge voltage of 150 V and an argon plasma was generated, and treatment was performed for 40 minutes using a bias voltage of -50 V. After cleaning the surfaces of the router by argon bombardment, an amorphous carbon film layer [A] having a thickness of 0.4 µm and an amorphous carbon film layer [B] having a thickness of 0.6 µm were formed. In order to obtain an amorphous carbon film layer [A] having an X value of about 0.30, the carbon vapor source was repeatedly discharged in a DC pulse mode at a frequency of 20 Hz using a discharge voltage of 250 V and a bias voltage of 0 V. As a result, the X value of the amorphous carbon film layer [A] was 0.291. In order to obtain an amorphous carbon film layer [B] having an X value of about 0.28, the carbon vapor source was repeatedly discharged in a DC pulse mode at a frequency of 20 Hz using a discharge voltage of 350 V and a bias voltage of 0 V. As a result, the X value of the amorphous carbon film layer [B] was 0.275.

### Test Example 8

After cleaning the surfaces of the router by argon bombardment using the same method and conditions as in test example 1, a Ti vapor source was discharged in a DC mode using a discharge voltage of 30 V and a bias voltage of -50 V, and a 0.05 µm Ti film layer was formed as a metal film layer [D]. An amorphous carbon film layer [A] having a thickness of 0.35 µm, an amorphous carbon film layer [B] having a thickness of 0.4 µm, and an amorphous carbon film layer [C] having a thickness of 0.2 µm were formed thereon. In order to obtain an amorphous carbon film layer [A] having an X value of about 0.36, the carbon vapor source was repeatedly discharged in a DC pulse mode at a frequency of 20 Hz using a discharge voltage of 100 V and a bias voltage of 0 V. As a result, the X value of the amorphous carbon film layer [A] was 0.362. In order to obtain an amorphous carbon film layer [B] having an X value of about 0.30, the carbon vapor source was repeatedly discharged in a DC pulse mode at a frequency of 20 Hz using a discharge voltage of 250 V and a bias voltage of 0 V. As a result, the X value of the amorphous carbon film layer [B] was 0.299. In order to obtain an amorphous carbon film layer [C] having an X value of about 0.28, the carbon vapor source was repeatedly discharged in a DC pulse mode at a frequency of 20 Hz using a discharge voltage of 350 V and a bias voltage of 0 V. As a result, the X value of the amorphous carbon film layer [C] was 0.279.

Using router coated with predetermined films, as shown in FIG. 3, cutting tests were performed according to the following cutting conditions, and machining distance (tool longevity) until the router was damaged or burrs formed on the machined surface was measured. Using aluminum sheeting (material: A5052; thickness: 1.0 mm) as the cut material, a 2.0 mm major diameter router was operated at a rotational speed of 30,000 min⁻¹ and a feed rate of 1.0 m/min to perform a test without cutting fluid (i.e., dry cutting).

FIG. 3 shows results for test examples of the present invention as well as for comparative examples in the form of conventional amorphous carbon films. Test examples 1-6 are not according to the invention.

It is apparent from FIG. 3 that routers coated with amorphous carbon films according to the present embodiment yield superior tool longevity and machined surface quality when cutting aluminum sheeting compared to routers coated with amorphous carbon films according to the comparative examples.

As shown in FIG. 4, steel bearing balls coated with predetermined films were used to measure distance until film peeling or wear using a ball-on-disc tribotester. There was an abrupt increase in the coefficient of friction in the tribotester when the film on the steel bearing ball peeled or was worn off. The distance until the increase in coefficient of friction was defined as the durability distance. Using a square sheet of mold steel (material: NAK55; size: 40 × 40 mm; thickness: 4 mm) as a disc, friction wear testing was performed by pressing steel bearing balls against the disc, which rotated at a predetermined velocity, under a load of 10 N without using a lubricant (i.e., dry testing). The relative speed (sliding speed) of the steel bearing ball and the disc in the test was set to 50 cm/s. Specifically, the disc was rotated at a rotational speed of 1,592 min⁻¹, and the steel bearing balls were pressed to and made to slide at a position at a 30 mm rotational radius of the disc.

FIG. 4 shows results for test examples of the present invention as well as for comparative examples in the form of conventional amorphous carbon films. Test examples 21-26 are not according to the invention.

It is apparent from FIG. 4 that steel bearing balls coated with amorphous carbon films according to the test examples yield superior wear resistance compared to steel bearing balls coated with amorphous carbon films according to the comparative examples.

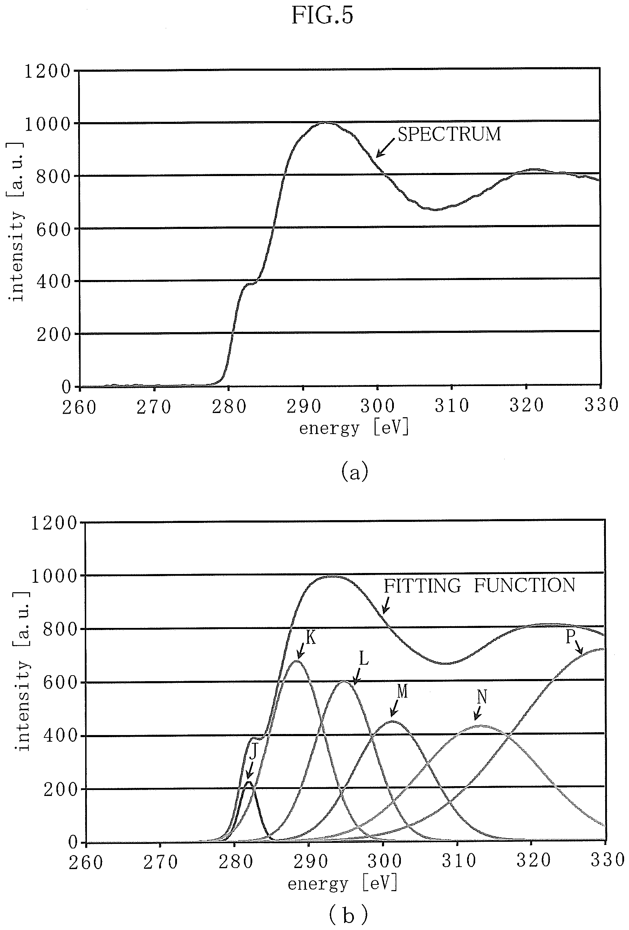

FIG. 5 shows electron energy loss spectroscopy results for the amorphous carbon film layer [A] of test example 5 in FIG. 3. Analysis was performed by irradiating a cross-section (a surface perpendicular to the surface of the substrate) of the amorphous carbon film with an electron beam having a spot diameter of 1.5 nm. FIG. 5(a) shows electron energy loss spectroscopy results. Peaks were extracted using the program PeakFit ver. 4.12 from SeaSolve assuming that the electron energy loss spectrum is the sum of the six Gaussian functions of J having a peak at 277-287 eV, K having a peak at 283-293 eV, L having a peak at 289-299 eV, M having a peak at 295-305 eV, N having a peak at 311-321 eV, and P having a peak at 325-335 eV. In FIG. 5(b), the J peak intensity IJ was 224.8, the L peak intensity IL was 601.0, and the value of X was 0.374. In order to confirm peak extraction suitability in FIG. 5(b), the sum of the six Gaussian functions J, K, L, M, N, and P is shown as a fitting function. The spectrum shown in FIG. 5(a) and the fitting function shown in FIG. 5(b) closely match, indicating that the peak extraction performed using the program PeakFit ver. 4.12 from SeaSolve yielded a good fit.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. An amorphous-carbon-containing film 0.1 µm to 1.5 µm in thickness coated onto a substrate of cemented carbide, steel, or ceramic, wherein the film is **characterized in** being constituted by an amorphous carbon film layer [A] and an amorphous carbon film layer [B] that each measure at least 0.05 µm in thickness and are layered so that the amorphous carbon film layer [A] is disposed nearer the substrate and the amorphous carbon film layer [B] is disposed nearer the surface, and, when a cross-section of the amorphous-carbon-containing film is irradiated with an electron beam to perform electron energy loss spectroscopy, X, which is defined as set forth below, is greater for the amorphous carbon film layer [A] than for the amorphous carbon film layer [B], X being 0.3-0.5 for the amorphous carbon film layer [A], an amorphous carbon film layer [C] being provided as an outermost layer, X being less for the amorphous carbon film layer [C] than for the amorphous carbon film layer [B] when a cross-section of the amorphous-carbon-containing film is irradiated with an electron beam to perform electron energy loss spectroscopy, the amorphous carbon-containing film containing no hydrogen apart from inevitable impurities, a metal film layer [D] being provided as a bottommost layer, the metal film layer [D] being constituted by at least one metal element from group 4a, 5a, or 6a of the periodic table, the metal film layer [D] measuring at least 0.01 µm and no more than 0.1 µm in thickness, and the amorphous carbon film layer [A] being provided over the metal film layer [D], wherein,
assuming that the electron energy loss spectrum measured via electron energy loss spectroscopy is the sum of the following six Gaussian functions (1) - (6), X is defined as IJ/IL, where IJ is the peak intensity of J and IL is the peak intensity of L when peaks are extracted from the electron energy loss spectrum,
(1) J having a peak at 277-287 eV
(2) K having a peak at 283-293 eV
(3) L having a peak at 289-299 eV
(4) M having a peak at 295-305 eV
(5) N having a peak at 311-321 eV
(6) P having a peak at 325-335 eV.

2. The amorphous-carbon-containing film according to claim 1, wherein the metal film layer [D] is constituted by Zr.

3. The amorphous-carbon-containing film according to any of claims 1 and 2, wherein the substrate is a cutting tool made of cemented carbide.

4. The amorphous-carbon-containing film according to any of claims 1 and 2, wherein the substrate is a router made of cemented carbide.

## Patentansprüche

1. Amorphen Kohlenstoff enthaltender Film mit einer Dicke von 0,1 µm bis 1,5 µm, der auf ein Substrat aus Sinterhartmetall, Stahl oder Keramik aufgebracht ist, wobei der Film **dadurch gekennzeichnet ist, dass** er durch eine amorphe Kohlenstofffilmschicht [A] und eine amorphe Kohlenstofffilmschicht [B] gebildet wird, die jeweils mindestens eine Dicke von 0,05 µm aufweisen und so geschichtet sind, dass die amorphe Kohlenstofffilmschicht [A] näher an dem Substrat angeordnet ist und die amorphe Kohlenstofffilmschicht [B] näher an der Oberfläche angeordnet ist, und, wenn ein Querschnitt des amorphen Kohlenstoff enthaltenden Films mit einem Elektronenstrahl bestrahlt wird, um eine Elektronenenergieverlustspektroskopie durchzuführen, X, das im Folgenden definiert ist, für die amorphe Kohlenstofffilmschicht [A] größer als für die amorphe Kohlenstofffilmschicht [B] ist, wobei X zwischen 0,3 und 0,5 für die amorphe Kohlenstofffilmschicht [A] beträgt, eine amorphe Kohlenstofffilmschicht [C] als eine äußerste Schicht vorgesehen ist, wobei X für die amorphe Kohlenstofffilmschicht [C] kleiner als für die amorphe Kohlenstofffilmschicht [B] ist, wenn ein Querschnitt des amorphen Kohlenstoff enthaltenden Films mit einem Elektronenstrahl bestrahlt wird, um eine Elektronenenergieverlustspektroskopie durchzuführen, der amorphen Kohlenstoff enthaltende Film keinen Wasserstoff enthält, ausgenommen unvermeidbare Verunreinigungen, eine Metallfilmschicht [D] als eine unterste Schicht vorgesehen ist, wobei die Metallfilmschicht [D] durch mindestens ein Metallelement aus der Gruppe 4a, 5a oder 6a des Periodensystems gebildet wird, die Metallfilmschicht [D] mindestens 0,01 µm und nicht mehr als 0,1 µm dick ist und die amorphe Kohlenstofffilmschicht [A] über der Metallfilmschicht [D] vorgesehen ist, wobei
angenommen, dass das Elektronenenergieverlustspektrum, das über Elektronenenergieverlustspektroskopie gemessen wird, die Summe der folgenden sechs Gauß-Funktionen (1) - (6) ist, X als IJ/IL definiert ist, wobei IJ die Peakintensität von J ist und IL die Peakintensität von L ist, wenn Peaks aus dem Elektronenenergieverlust-Spektrum extrahiert werden, wobei
(1) J einen Peak bei 277-287 eV aufweist
(2) K einen Peak bei 283-293 eV aufweist
(3) L einen Peak bei 289-299 eV aufweist
(4) M einen Peak bei 295-305 eV aufweist
(5) N einen Peak bei 311-321 eV aufweist
(6) P einen Peak bei 325-335 eV aufweist.

2. Amorphen Kohlenstoff enthaltender Film nach Anspruch 1, bei dem die Metallfilmschicht [D] durch Zr gebildet wird.

3. Amorphen Kohlenstoff enthaltender Film nach einem der Ansprüche 1 und 2, bei dem das Substrat ein aus Sinterhartmetall hergestelltes Schneidwerkzeug ist.

4. Amorphen Kohlenstoff enthaltender Film nach einem der Ansprüche 1 und 2, bei dem das Substrat ein aus Sinterhartmetall hergestellter Nuthobel ist.

## Revendications

1. Film contenant du carbone amorphe de 0,1 µm à 1,5 µm d'épaisseur revêtu sur un substrat de carbure cémenté, d'acier ou de céramique, dans lequel le film est **caractérisé par le fait qu'**il est constitué d'une couche de film de carbone amorphe [A] et d'une couche de film de carbone amorphe [B] qui mesure chacune au moins 0,05 µm d'épaisseur et sont stratifiée de manière à ce que la couche de film de carbone amorphe [A] est disposée plus près du substrat et que la couche de film de carbone amorphe [B] est disposée plus près de la surface, et, lorsqu'une section transversale du film contenant du carbone amorphe est irradiée avec un faisceau d'électrons pour effectuer une spectroscopie de perte d'énergie d'électrons, X, qui est définie comme indiqué ci-dessous, est plus grand pour la couche de film de carbone amorphe [A] que pour la couche de film de carbone amorphe [B], X étant 0,3 à 0,5 pour la couche de film de carbone amorphe [A], une couche de film de carbone amorphe [C] étant prévue comme couche la plus à l'extérieur, X étant inférieur pour la couche de film de carbone amorphe [C] que pour la couche de film de carbone amorphe [B] lorsqu'une coupe transversale du film contenant du carbone amorphe est irradié par un faisceau d'électrons pour effectuer une spectroscopie de perte d'énergie d'électrons, le film contenant du carbone amorphe ne contenant pas d'hydrogène en dehors des impuretés inévitables, une couche de film métallique [D] étant prévue comme couche la plus inférieure, la couche de film métallique [D] étant constituée d'au moins un élément métallique du groupe 4a, 5a ou 6a de la classification périodique, la couche de film métallique [D] mesurant au moins 0,01 µm et pas plus que 0,1 µm d'épaisseur, et la couche de film de carbone amorphe [A] étant disposée sur la couche de film métallique [D], dans lequel,
en supposant que le spectre de perte d'énergie d'électrons mesuré via la spectroscopie de perte d'énergie d'électrons est la somme des six fonctions Gaussienne suivantes (1) à (6), X est défini par IJ/IL, où IJ est le pic d'intensité de J et IL est le pic d'intensité de L lorsque les pics sont extraits du spectre de perte d'énergie d'électrons,
(1) J présentant un pic à 277-287 eV
(2) K présentant un pic à 283-293 eV
(3) L présentant un pic à 289-299 eV
(4) M présentant un pic à 295-305 eV
(5) N présentant un pic à 311-321 eV
(6) P présentant un pic à 325-335 eV.

2. Film contenant du carbone amorphe selon la revendication 1, dans lequel la couche de film métallique [D] est constituée de Zr.

3. Film contenant du carbone amorphe selon l'une quelconque des revendications 1 et 2, dans lequel le substrat est un outil de coupe fait de carbure cémenté.

4. Film contenant du carbone amorphe selon l'une quelconque des revendications 1 et 2, dans lequel le substrat est une fraiseuse fait de carbure cémenté.
